# EUROPEAN PATENT SPECIFICATION

(11) **EP 2 716 148 B1**
(45) Date of publication and mention of the grant of the patent: **14.02.2018**
(21) Application number: 12731712.1
(22) Date of filing: 30.05.2012
(51) Int. Cl.: H05K 7/20

(54) **AN ASSEMBLY ARRANGEMENT OF AN INVERTER FOR CONTROLLING HYDRAULIC PUMPS**
MONTAGEANORDNUNG EINES WECHSELRICHTERS ZUR STEUERUNG VON HYDRAULISCHEN PUMPEN
DISPOSITION DE MONTAGE D'UN ONDULEUR POUR LA COMMANDE DE POMPES HYDRAULIQUES

(30) Priority: 03.06.2011 IT FI20110115
(43) Date of publication of application: 09.04.2014
(73) Proprietor: Mac 3 S.p.A., 59100 Prato (IT)
(72) Inventor: RONCHI, Mirian, I-50133 Firenze (IT)
(74) Representative: Soldatini, Andrea
(86) International application number: PCT/IB2012/052686
(87) International publication number: WO 2012/164492

(56) References cited:
- EP-A1- 2 275 299
- DE-A1-102007 053 561
- US-A- 5 606 239
- US-A1- 2009 284 923

## Description

### Field of the invention

The present invention refers to the field of hydraulic systems and, in particular, to an assembly arrangement of an inverter for controlling hydraulic pumps in water distribution facilities.

### Background of the invention

To provide the head and flow necessary to supply the water consumers in a building, therefore making up for a shortage in the source of supply (such as, for example, the public water network, wells, etc.), pressurization plants destined to increase water pressure with respect to the one supplied by the distribution network are used; these are actually water lifting units with constant pressure which allow the water flow taken from the network or from storage tanks to also reach those consumers who live on the highest floors.

A commonly used system is the so-called *autoclave* and generally comprises at least one storage tank for storing a given amount of water coming from the network, at least one electric pump, usually of centrifugal kind, with appropriate flow and head, a pressurized container comprising a plenum chamber and a pressure switch, i.e. a switch capable of turning the pump on according to the water pressure.

Constant speed single rotor pumps are commonly used in lifting units with constant pressure. This type of pump has a constant energy consumption, both when working in a low intake condition and working at the projected flow rate, since it always operates at the maximum speed.

The pump is sized on the basis of the consumers' peaks of maximum consumption: however, peaks of maximum consumption (corresponding to the simultaneous use by all the connected consumers) are statistically rare; therefore, during the functioning at low intake conditions (i.e. those in which only some consumers are using the water service, statistically a more frequent condition), the pump, having a fixed speed, unnecessarily uses more energy with respect to that it would really need.

To reduce consumptions and optimize the functioning of the plant, inverter devices are used, i.e. static frequency converters which control the RPM of the single-phase or three-phase asynchronous motor pumps using the common single-phase line, thus reducing energy consumption in a significant way. Inverters are pump electronic control devices which ensure a constant pressure as the flow changes, thus guaranteeing a significant energy saving. This result is obtained thanks to the fact that the inverter increases or decreases the frequency of the pump on the basis of the need and of the number of consumers using the service. In fact, in pumps the relationship between the power absorbed and the rotation speed of the impeller is of the cubic type; therefore, a slight decrease in the rotation speed implies a significant decrease in the power absorbed.

A particularly common problem in relation to the use of inverters is associated with the cooling of the electronic components which form the inverter itself; in this respect, the inverter mainly comprises a micromethodor circuit board for managing and controlling power electronic components comprising IGBT rectifiers (or, alternatively, IGGT, MOSFET rectifiers or transistors). These very power components are those which, at high output, imply a significant heat emission and, therefore, are mostly responsible for the overheating of the inverter. The heat produced by these components therefore needs to be dispersed through suitable cooling systems.

However, the cooling applied to the inverters presently used is often not sufficient to eliminate breaking problems or malfunctions. These faults imply significant costs for the consumers, who are obliged to request qualified technical interventions to repair and/or substitute the inverter.

To increase the cooling effect and at the same time thermally insulate the inverter in the best possible way, the electronic components are assembled on boxes or other plastic covers which can also integrate the duct for the flowing of water (in-line assembly). They are quite bulky units, difficult to install and all the more so to be replaced in case of faults.

The application EP2275299 discloses a working machine wherein an arrangement of an inverter for controlling at least one hydraulic pump is provided.

### Summary of the invention

The object of the present invention is to solve the above mentioned problems providing a new arrangement of such a type of inverter, which makes the assembly and maintenance operations considerably easier, with consequent cost reductions and, at the same time, guarantees a surprisingly effective cooling of the electronic components comprised in the inverter itself.

This and other objects are achieved by the assembly arrangement of an inverter, and by the relative method according to the present invention, the essential features of which are defined in the appended claims.

### Brief description of the drawings

The characteristics and advantages of the inverter arrangement and of the relevant method according to the present invention will be apparent from the following description of an embodiment thereof, given as a non-limiting example with reference to the attached drawings, wherein:
- figure 1 is a perspective view of a metallic tubular body of the inverter according to the invention; and
- figure 2 shows, in a similar view, a different version of the tubular body of figure 1.

### Detailed description of the invention

With reference to the above figures, as known *per se,* an inverter for controlling a pump, in particular but not limited to an autoclave water plant for the distribution of drinking water, substantially comprises, as known *per se,* a microprocessor circuit board for controlling and managing the power electronic components comprising, in their turn, a rectifier, i.e. a device allowing the transformation of alternate current into direct current through a IGBT (Insulated Gate Bipolar Transistor - a device for commuting high voltages or high currents) or the like.

Moreover, sensors for detecting the method parameters (such as pressure sensors) are associated with the circuit board. Furthermore, a management and control panel for the user to interact with the inverter is also commonly provided.

The set of electronic elements mentioned above is housed in a special cover (which is not shown in the figures, like the elements themselves) which allows their perfect containment and, at the same time, protects the components from atmospheric agents.

According to the main aspect of the present invention, and as indeed shown in the figures, the circuit board, and more in particular the power components associated with it, i.e. the rectifier, is fixed directly on a cylindrical tubular body 1, with main axis X, made of a metallic material, typically and preferably iron, galvanized steel or stainless steel, which is assembled in-line on the duct of the plant to be controlled. To this aim, i.e. to carry out the above assembly, in the outer surface 10 of the tubular body 1, at an intermediate position (with reference to the axis X), a seat 2 is formed, defined by a flattened portion 20, preferably on a plane parallel to the axis X, which can be obtained by way of example with a mechanical method of deformation of the very outer surface 10; preferably, the flattened portion is obtained through the flattening and following milling of the outer surface 10.

From the flattened portion 20 studs 21 adapted to allow the direct fastening of the board to the body 1 perpendicularly project outwards. To this purpose, fastening nuts screwing on studs will be used, the latter being engaged with perforations formed in the electronic components (and in particular on the board), to obtain a firm fastening against the body 1.

Generally, the electronic board is configured to engage with the metallic tubular body so that the electronic components associated with the board, which need a greater heat loss, result in a relationship of conductive heat transfer with the tubular body and, therefore, in the most direct contact possible.

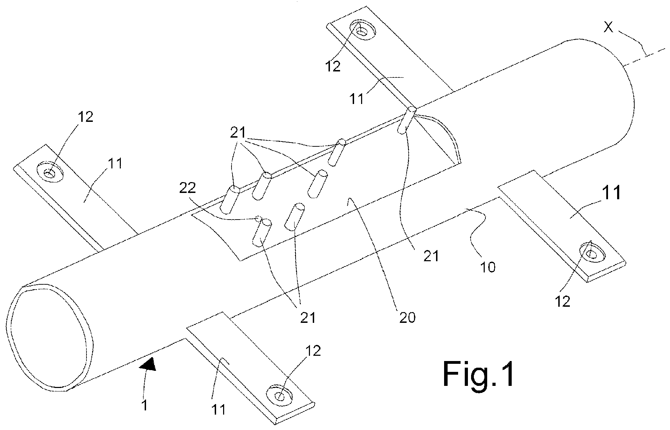

The embodiment in figure 1 also shows an orifice 22 formed in the flattened portion 20 and which allows to detect a signal of pressure through a suitable traditional membrane sensor. The detection of pressure can in any case be carried out also outside the tubular body, i.e. in a point of the duct upstream or downstream the tubular body itself.

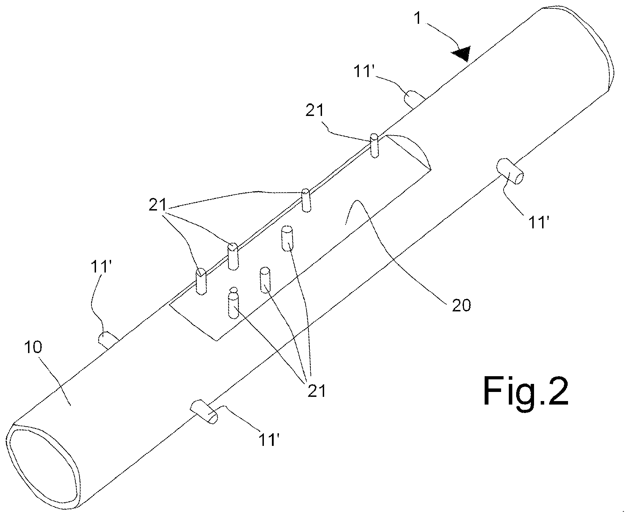

With specific reference again to the embodiment in figure 1, from the tubular body 1 and, in particular, from the outer surface 10, wings 11 project along a plane which passes through the axis X and is parallel to the flattened portion 20. In particular, in the example given in the figure, the wings are four and have screw holes 12 for connecting to the already mentioned cover for the protection of the electronic elements comprised in the inverter. Moreover, the examples given in the other figure 2 show how the wings 11 can be replaced by projections 11' shaped in a different manner, by way of example as pivots, with a similar functionality.

The tubular body 1 also has axial ends with a suitable working, by way of example a threading, for the in-line insertion and integration in the plant duct. As a matter of fact, a part of the network duct is substituted by the tubular body 1 which also serves as direct support for the power components.

The assembly procedure of the inverter therefore provides for the fixing of the electronic components to the tubular body; the inverter so assembled can therefore be mounted on the duct by inserting the metallic tubular body 1 on the duct at a predefined position, in particular at the outlet of the pump. Such a position corresponds to an interruption of the duct itself destined to be completed by the tubular body. Therefore, the tubular body is made integral with the duct terminals with a sealed connection obtained by means of conventional three-piece joints. Downstream of the inverter a valve is also provided to allow for its decompression.

The advantages of the invention can therefore be summarized as follows.

The power components, the ones most subject to heat production, are cooled by the direct contact with the duct and by the relating flow of water inside it, therefore increasing the effect of conductive heat transfer and considerably improving the cooling effect, in a surprising way in particular considering the simplicity of the solution, with respect to known systems. This has a very positive impact on the life span of the inverter and on its regular functioning.

In addition, the inverter is easy to assemble and the maintenance is in particular made easier by the fact that the electronic components can be made accessible and even replaced singularly without damaging the hydraulic integrity of the plant at all (and, as a consequence, without emptying the plant, this being a result which in the known technique can only be obtained with out of line installations).

The connection of the tubular body to the plant is obtained through threadings on the metallic duct, avoiding all the disadvantages due to certain plastic moulds which are particularly fragile and can be easily deformed during the assembly and the screwing, with consequent lack of hydraulic seal of the duct. On the contrary, the integral metal tube is completely safe (bearing pressures up to 40/50 bars) and allow for getting rid of metal inserts on the plastic casing, the flattened portion being sufficient to provide for a completely effective cooling.

The power capacitors of the inverter can possibly be arranged also sideways benefiting from the cooling effect that can dramatically lengthen the life of this type of components.

The inverter can in any case and advantageously be sold already in the assembly configuration or with the components already associated with the tubular body. The fixing system of the electronic components to the tubular body can also provide for different solutions with respect to that of studs and nuts mentioned above, by way of example gluing systems.

The metal tube distinct from the plastic casing permit to obtain the molding of the latter as a normal plastic body, with no need for costly and lengthy arrangements of metal inserts.

As said, the arrangement of an inverter here described is not limited to be used in autoclave plants but can also be used in hydraulic plants having similar control needs.

The present invention has been here described with reference to its preferred embodiments. It should be understood that that there may be other embodiments within the same inventive concept, all defined by the scope of protection of the following claims.

## Claims

1. An arrangement of an inverter for controlling at least one hydraulic pump, said arrangement comprising power and control electronic components and a straight length of a tubular metallic body (1) to be assembled in-line on a duct for the flowing of a fluid in a hydraulic plant, at least said power electronic components being connected with said tubular body so as to result in a relationship of conductive heat transfer with the same body, said electronic components being fixed to said tubular body (1), so as to abut against an outer surface (10) of the body, said arrangement being **characterised in that** said tubular body (1) comprises threaded ends for the hydraulic connection with corresponding ends of said duct.

2. The arrangement according to claim 1, wherein a seat is formed in said outer surface (10) of said tubular body (1), said seat comprising a flattened portion (20) for the abutment of said electronic components.

3. The arrangement according to claim 2, wherein screw studs (21) project from said flattened portion (20), said electronic components engaging with said screw studs (21) along with correspondent screw nuts for fastening said components.

4. The arrangement according to claim 2 or 3, wherein wings (11) project from said outer surface (10) according to a plane parallel with said flattened portion (20), said wings (11) being adapted to permit the connection of the body (1) with a cover for the protection and the housing of said electronic components.

5. The arrangement according to any of the claims from 2 to 5, wherein an orifice (22) is formed in said flattened portion (20) to permit the measurement of a signal pressure, by means of an appropriate sensor.

6. The arrangement according to any of the previous claims, wherein said electronic power components comprises a IGBT rectifier.

7. The arrangement according to any of the previous claims, wherein said tubular body is made of iron or galvanised steel.

8. A method for arranging an inverter on a duct line of an hydraulic plant, said inverter being adapted to control at least one hydraulic pump of said plant, said inverter comprising power and control electronic components, said method being **characterised in**: - providing a metal tubular body (1) with said components associated thereon, so that at least said power electronic components result in a relationship of conductive heat transfer with the same body (1); - inserting said body in-line on said duct.

9. The method according to claim 8 , further comprising: assembling a cover on said tubular body (1) for the protection and the housing of said electronic components.

10. The method according to claim 8 or 9 , wherein said tubular body (1) is inserted in correspondence with an interruption formed or provided in said duct.

11. The method according to any of the claims from 8 to 10, carried out with the arrangement of an inverter according to any of the claims from 1 to 7.

## Patentansprüche

1. Anordnung eines Inverters zum Steuern wenigstens einer hydraulischen Pumpe, wobei die Anordnung Leistungs- und Steuer-Elektronikkomponenten und eine gerade Länge eines rohrartigen metallischen Körpers (1) enthält, der in Reihe an einer Leitung für die Strömung eines Fluids in einer hydraulischen Anlage zu montieren ist, wobei wenigstens die Leistungs-Elektronikkomponenten mit dem rohrartigen Körper verbunden sind, um einen Zusammenhang einer leitenden Wärmeübertragung mit selbigem Körper zur Folge zu haben, wobei die Elektronikkomponenten an dem rohrartigen Körper (1) befestigt sind, um gegen eine äußere Oberfläche (10) des Körpers anzuliegen, wobei die Anordnung **dadurch gekennzeichnet ist, dass** der rohrartige Körper (1) mit Gewinden versehene Enden für die hydraulische Verbindung mit entsprechenden Enden der Leitung enthält.

2. Anordnung nach Anspruch 1, wobei ein Sitz in der äußeren Oberfläche (10) des rohrartigen Körpers (1) ausgebildet ist, wobei der Sitz einen abgeflachten Teil (20) für die Anlage der Elektronikkomponenten enthält.

3. Anordnung nach Anspruch 2, wobei Gewindestifte (21) von dem abgeflachten Teil (20) vorstehen, wobei die Elektronikkomponenten mit den Gewindestiften (21) zusammen mit entsprechenden Gewindemuttern zum Befestigen der Komponenten in Eingriff sind.

4. Anordnung nach Anspruch 2 oder 3, wobei Flügel (11) von der äußeren Oberfläche (10) gemäß einer Ebene parallel zu dem abgeflachten Teil (20) vorstehen, wobei die Flügel (11) ausgelegt sind, um die Verbindung des Körpers (1) mit einer Abdeckung zum Schutz und zur Unterbringung der Elektronikkomponenten zu gestatten.

5. Anordnung nach einem der Ansprüche 2 bis 4, wobei eine Öffnung (22) in dem abgeflachten Teil (20) ausgebildet ist, um die Messung eines Signaldruckes mittels eines geeigneten Sensors zu gestatten.

6. Anordnung nach einem der vorhergehenden Ansprüche, wobei die elektronischen Leistungskomponenten einen IGBT-Gleichrichter enthalten.

7. Anordnung nach einem der vorhergehenden Ansprüche, wobei der rohrartige Körper aus Eisen oder galvanisiertem Stahl hergestellt ist.

8. Verfahren zum Anordnen eines Inverters an einem Leitungskanal einer hydraulischen Anlage, wobei der Inverter ausgelegt ist, wenigstens eine hydraulische Pumpe der Anlage zu steuern, wobei der Inverter Leistungs- und Steuer-Elektronikkomponenten enthält, wobei das Verfahren **gekennzeichnet durch**: - Bereitstellen eines rohrartigen metallischen Körpers (1) mit den damit verbundenen Komponenten, so dass wenigstens die Leistungs-Elektronikkomponenten in einem Zusammenhang einer leitenden Wärmeübertragung mit selbigem Körper (1) resultieren; - Einsetzen des Körpers an der Leitung.

9. Verfahren nach Anspruch 8, wobei ferner enthalten ist: Montieren einer Abdeckung an dem rohrartigen Körper (1) zum Schutz und zur Unterbringung der Elektronikkomponenten.

10. Verfahren nach Anspruch 8 oder 9, wobei der rohrartige Körper (1) entsprechend einer Unterbrechung eingesetzt wird, die in der Leitung ausgebildet oder vorgesehen ist.

11. Verfahren nach einem der Ansprüche 8 bis 10, wobei es mit der Anordnung eines Inverters nach einem der Ansprüche 1 bis 7 ausgeführt wird.

## Revendications

1. Un dispositif de montage d'un onduleur pour commander au moins une pompe hydraulique, ledit dispositif de montage comprenant des composants électroniques de puissance et de commande et une longueur rectiligne d'un corps métallique tubulaire (1) à assembler en ligne avec une conduite pour l'écoulement d'un fluide dans une installation hydraulique, lesdits composants électroniques de puissance étant reliés audit corps tubulaire de façon qu'ils aient une relation de transfert de chaleur par conduction avec ce même corps, lesdits composants électroniques étant fixés sur ledit corps tubulaire (1) de façon à être en butée contre une surface extérieure (10) du corps, ledit dispositif de montage étant **caractérisé en ce que** ledit corps tubulaire (1) comprend des extrémité filetées pour une connexion hydraulique avec des extrémités correspondantes de ladite conduite.

2. Le dispositif selon la revendication 1, dans lequel un siège est formé dans ladite surface extérieure (10) dudit corps tubulaire (1), ledit siège comprenant une partie aplatie (20) contre laquelle viennent en butée lesdits composants électroniques.

3. Le dispositif selon la revendication 2, dans lequel des goujons filetés (21) font saillie à partir de ladite partie aplatie (20), lesdits composants électroniques coopérant avec lesdits goujons filetés (21) ainsi qu'avec des écrous taraudés correspondants pour fixer lesdits composants.

4. Le dispositif selon l'une des revendications 2 et 3, dans lequel des ailettes (11) font saillie à partir de ladite surface extérieure (10) dans un plan parallèle à ladite partie aplatie (20), lesdites ailettes (11) étant adaptées pour permettre la connexion du corps (1) avec un couvercle pour la protection et le logement desdits composants électroniques.

5. Le dispositif selon l'une quelconque des revendications 2 à 5, dans lequel un orifice (22) est réalisé dans ladite partie aplatie (20) pour permettre la mesure d'un signal de pression, au moyen d'un capteur approprié.

6. Le dispositif selon l'une quelconque des revendications précédentes, dans lequel les composants électroniques de puissance comportent un redresseur IGBT.

7. Le dispositif selon l'une quelconque des revendications précédentes, dans lequel ledit corps tubulaire est réalisé en fer ou en acier galvanisé.

8. Un procédé pour réaliser un montage d'un onduleur sur une ligne de conduite d'une installation hydraulique, ledit onduleur étant adapté pour commander au moins une pompe hydraulique de ladite installation, ledit onduleur comprenant des composants électroniques de puissance et de commande, ledit procédé étant **caractérisé par le fait qu'**il consiste en :
- la fourniture d'un corps tubulaire métallique (1) avec lequel lesdits composants sont associés, de façon qu'au moins les composants électroniques de puissance aient une relation de transfert de chaleur par conduction avec ce même corps (1) ; et en
- l'insertion en ligne dudit corps sur ladite conduite.

9. Le procédé selon la revendication 8, comprenant en outre : l'assemblage d'un couvercle sur ledit corps tubulaire (1) pour la protection et le logement desdits composants électroniques.

10. Le procédé selon l'une des revendications 8 et 9, dans lequel ledit corps tubulaire (1) est inséré en correspondance avec une interruption formée ou prévue dans ladite conduite.

11. Le procédé selon l'une quelconque des revendications 8 à 10, mis en oeuvre avec le dispositif de montage d'un onduleur selon l'une quelconque des revendications 1 à 7.
